# FASCICULE DE BREVET EUROPEEN

(11) **EP 3 925 208 B1**
(45) Date de publication et mention de la délivrance du brevet: **05.04.2023**
(21) Numéro de dépôt: 20702500.8
(22) Date de dépôt: 06.02.2020
(51) Int. Cl.: H04N 5/376, H03K 17/06, G09G 3/36, G11C 19/28

(54) **DÉTECTEUR MATRICIEL AYANT UN EFFET PAIR/IMPAIR RÉDUIT**
ARRAY-DETEKTOR MIT VERRINGERTEM GERADE/UNGERADE -EFFEKT
ARRAY DETECTOR HAVING REDUCED EVEN/ODD EFFECT

(30) Priorité: 11.02.2019 FR 1901328
(43) Date de publication de la demande: 22.12.2021
(73) Titulaire: ISORG, 87068 Limoges Cedex 3 (FR)
(72) Inventeur: BLANCHON, David, 38040 GRENOBLE CEDEX 09 (FR); FEI, Richun, 38040 GRENOBLE CEDEX 09 (FR)
(74) Mandataire: Cabinet Beaumont
(86) Numéro de dépôt international: PCT/EP2020/053024
(87) Numéro de publication internationale: WO 2020/165024

(56) Documents cités:
- FR-A1- 2 975 213
- US-A1- 2013 328 612

## Description

L'invention se rapporte à un détecteur matriciel, dans lequel les effets des capacités parasites liés à des signaux d'horloges différents, sont réduits. Elle trouve son application notamment pour des capteurs apte à détecter un signal fonction d'un phénomène physique, et en particulier pour des capteurs d'images.

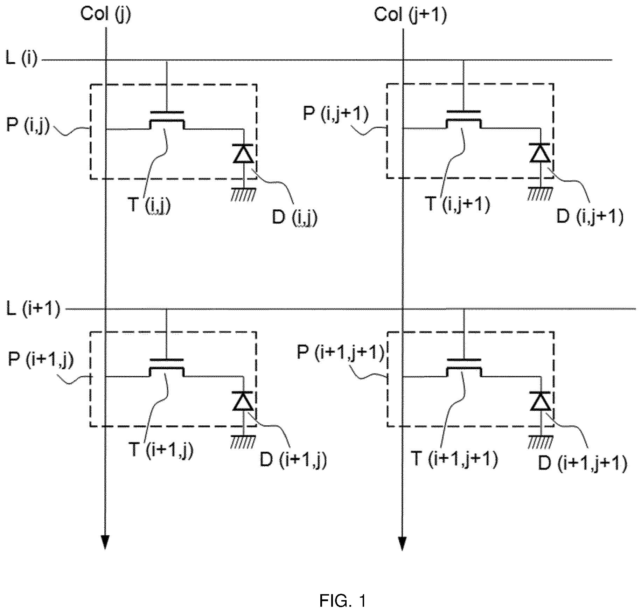

Les détecteurs matriciels sont, de façon connue, composés de pixels, formés à l'intersection de lignes et de colonnes d'une matrice. La figure 1 illustre l'agencement en lignes et en colonnes des pixels d'un détecteur. Chaque pixel P(i,j) est composée d'un capteur de lumière D(i,j), généralement une photodiode, qui génère des charges en proportion de l'énergie lumineuse reçue et les stocke dans sa capacité, et d'un dispositif de commutation T(i,j), dont la source est connectée au détecteur de charge D(i,j). En particulier, le dispositif de commutation peut être un transistor en couches minces T(i,j).

L'adressage séquentiel des lignes L(i) demande de fournir deux tensions distinctes : une tension Voff pour maintenir non passants tous les transistors T(i,j) d'une ligne L(i) et une tension Von pour rendre passant tous les transistors T(i,j) d'une ligne L(i). Les transistors T(i,j) sont adressés par un jeton de sélection (ou « token » selon la terminologie anglo-saxonne). Le jeton de sélection est un signal de niveau haut (tension Von) durant un instant prédéterminé, par rapport à un niveau bas (tension Voff inférieure à Von), qui se propage de ligne en ligne, dans un sens donné, par exemple de la ligne L(i) à la ligne L(i+1).

Au moment où le jeton de sélection se propage dans une ligne L(i), le niveau haut du jeton commande l'état passant de tous les transistors de la ligne. Le niveau haut du jeton de sélection est configuré pour avoir une valeur supérieure à la tension de seuil des transistors. Les électrons stockés dans chacun des détecteurs de charge D(i,j) de la ligne sont transmis à un intégrateur de charge via la colonne Col(j) associée au pixel P(i,j), qui transforme cette valeur en tension. La colonne Col(j) est reliée à la source du transistor T(i,j). L'intégration des charges dans chaque colonne est gérée par des adresseurs de colonnes.

La propagation du jeton de sélection de la ligne L(i) à la ligne suivante L(i+1) est gérée par un dispositif d'adressage de ligne, ou balayeur de lignes, appelé couramment « driver de ligne », ou « gate driver ». Le dispositif d'adressage de ligne est un registre à décalage, comprenant une pluralité d'étages. Chaque étage est connecté à une ligne de la matrice. Un générateur de signaux, qui génère deux signaux d'horloge déphasés l'un par rapport à l'autre, est connecté au dispositif d'adressage. A chaque coup d'horloge, le jeton de sélection se propage dans le dispositif d'adressage, en passant d'un étage au suivant.

Les dispositifs d'adressage de ligne étaient initialement disposés en dehors de la matrice, reliés à la matrice par exemple par des nappes flexibles. Plus récemment sont apparus des dispositifs d'adressage de ligne implémentés directement dans la matrice, en utilisant des transistors TFT de type unique N ou P. La matrice peut être réalisée par un dépôt de couches sur un substrat, par exemple de type silicium amorphe (a-Si), TFT, silicium polycristallin, semiconducteur organique, oxyde de zinc Gallium Indium amorphe (Ga₂O₃-In₂O₃-ZnO).

Ces dispositifs d'adressage intégrés dans la matrice, couramment appelés GOA (Gate driver On Array) permettent de gagner en coût de fabrication, en place occupée, et permet de limiter les erreurs de connexion par rapport aux dispositifs d'adressage externes.

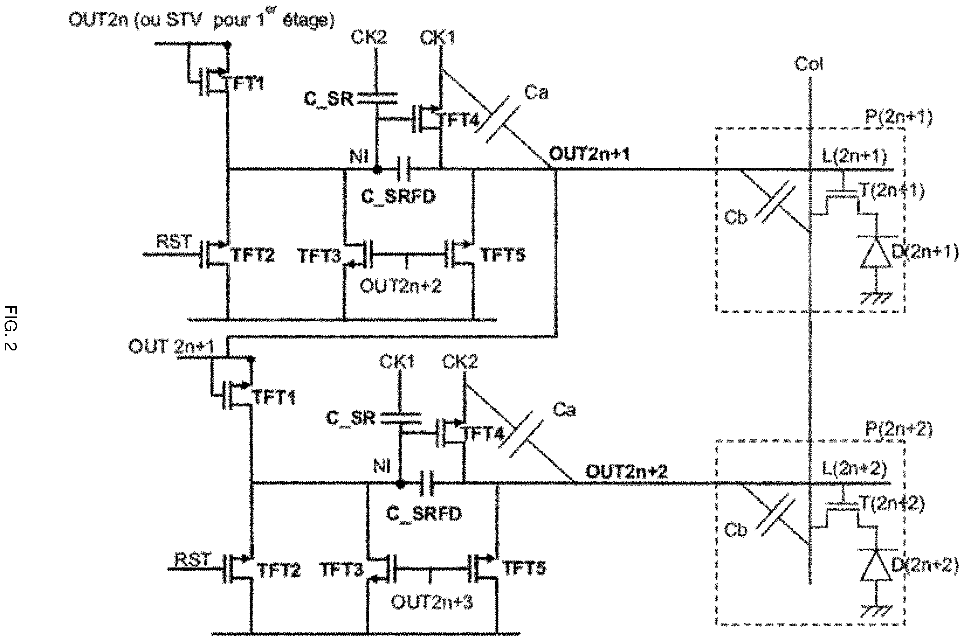

La figure 2 illustre un schéma électrique représentant deux étages consécutifs d'un dispositif d'adressage de matrice. Les deux étages représentés correspondent à des étages pilotés par deux signaux d'horloge différents, à savoir un premier signal d'horloge CK1, et un deuxième signal d'horloge CK2. Par convention, on appellera, dans la présente demande, « étage impair » un étage piloté par le premier signal d'horloge CK1, et « étage pair » un étage piloté par le deuxième signal d'horloge CK2. La figure 2 illustre donc le schéma électrique d'un étage impair et d'un étage pair. Chaque étage est relié à une ligne comprenant une pluralité de pixels, comme décrit précédemment.

Chaque étage comprend une ligne de sortie restituant en sortie un signal d'activation (Out2n+1, Out2n+2). L'étage comprend un transistor de sortie TFT4, qui transmet une impulsion d'un signal d'horloge au niveau de la sortie de l'étage. La grille du transistor de sortie TFT4 peut être connectée à un noeud interne NI de l'étage, sa source peut être reliée à la sortie Out2n+1 et son drain peut recevoir le signal d'une première horloge CK1. Un condensateur d'élévation C_SRFD peut être connecté entre la grille et la source du transistor de sortie de l'étage d'entrée TFT4. Un premier transistor de commande de l'étage TFT1 (transistor de mise à niveau haut, ou « pull-up ») est apte à précharger la grille du transistor de sortie TFT4. La source du premier transistor de commande TFT1 est ainsi connectée à la grille du transistor de sortie TFT4. La grille et le drain du premier transistor de commande TFT1 sont commandés par la sortie de l'étage précédent (étage 2n). Pour le premier étage du dispositif d'adressage, la grille et le drain du premier transistor de commande TFT1 sont commandés par le générateur de signal GSI, qui génère une impulsion STV.

Le générateur de signaux GSI peut comprendre un circuit dédié, par exemple un circuit de type FPGA, couplé à un convertisseur de niveau. Le FPGA reçoit des signaux de commande transmis par un dispositif de calcul (non représenté). Le FPGA génère les signaux logiques en faible tension (par exemple entre 0 et 3,3 V). Le convertisseur de niveau assure la compatibilité entre les faibles tensions du FPGA, et les tensions plus élevées de la matrice (Von, Voff).

Un deuxième transistor de commande TFT3 est apte à décharger la grille du transistor de sortie TFT4. Le drain du deuxième transistor de commande TFT3 est ainsi connecté à la grille du transistor de sortie TFT4.

Un transistor de décharge TFT5 (transistor de mise à niveau bas, ou « pull-down ») peut être connecté à la sortie de l'étage Out2n+1. La grille du transistor de décharge TFT5 est reliée à la grille du deuxième transistor de commande TFT3 ; elle est également reliée au signal de sortie Out2n+2 de l'étage suivant.

La propagation du jeton s'effectue ainsi d'étage en étage, jusqu'à ce que toutes les lignes de la matrice aient été lues.

Le document US 2013/0088265 A1 décrit un autre exemple de GOA. Le document FR 2 975 213 A1 décrit un dispositif d'adressage des lignes d'une matrice active de détection pour imagerie par rayonnements ionisants comprenant une pluralité de lignes de pixels. Le dispositif d'adressage est réalisé sur un substrat sur lequel est également réalisée la matrice, et comprend essentiellement des transistors couches minces (TFT) de type unique N ou P.

Le principe de l'adressage de lignes dans les afficheurs, et dans les détecteurs, est sensiblement le même. En effet, deux horloges différentes (premier signal CK1, et deuxième signal CK2) pilotent le transistor de sortie, en alternant d'un étage à l'autre. La variation de tension entre le niveau haut et le niveau bas des signaux d'horloge peut atteindre plusieurs dizaines de volts. Cette variation brutale engendre des signaux parasites, dus à la capacité de la grille, avec des pics dont la valeur peut atteindre quelques volts au niveau de la sortie de l'étage, à chaque front montant et à chaque front descendant du signal d'horloge fourni à l'étage (CK1 pour les étages impairs, CK2 pour les étages pairs).

Ainsi, au niveau de chaque étage, même lorsque le jeton ne se propage pas dans l'étage (et donc avec un transistor de sortie TFT4 bloquant), un couplage parasite a lieu entre le signal d'horloge, qui arrive au niveau du drain du transistor de sortie TFT4, et la ligne menant aux pixels. De même, au niveau du transistor T(2n+1) du pixel P(2n+1), l'effet capacitif de la grille engendre des signaux parasites sur la colonne. Ces différents couplages parasites (horloge/ligne et ligne/colonne) sont matérialisés sur la figure 2, respectivement par les capacités Ca et Cb.

Le couplage provoqué par le premier signal d'horloge CK1 se retrouve dans toutes les lignes connectées au premier signal d'horloge CK1. Sur un détecteur matriciel de deux mille lignes, lors de l'intégration des charges au niveau de chaque colonne, le couplage provoqué par le premier signal d'horloge CK1 est donc multiplié par mille. Il en va de même du couplage provoqué par le deuxième signal d'horloge CK2.

Dans le domaine des afficheurs, ces couplages parasites ne posent pas de difficultés, dans la mesure où une tension, correspondant au signal de données à afficher, est appliquée au niveau de chaque colonne. En revanche, dans le domaine des détecteurs, étant donné la faible quantité de charges du signal utile, les valeurs des couplages parasites peuvent largement dépasser la valeur des signaux à détecter. Typiquement, les valeurs des couplages parasites peuvent atteindre deux à trois cents fois la valeur du signal utile. La présence, sur une même colonne, de charges parasites ayant des valeurs différentes d'une ligne à l'autre, empêche d'effectuer un traitement correctif permettant de distinguer les charges parasites liées aux lignes paires, et les charges parasites liées au lignes impaires. Dans la présente demande, on appellera « effet pair/impair » le fait d'avoir, dans les colonnes, des signaux parasites issus de signaux d'horloges différents (certains signaux sur les lignes paires, d'autres sur les lignes impaires).

L'invention vise donc à fournir un détecteur matriciel, permettant de réduire l'effet pair/impair. L'invention vise également à fournir un détecteur matriciel présentant un bruit parasite réduit.

Un objet de l'invention est donc un détecteur matriciel comprenant :
- un ensemble de pixels organisés en matrice selon des lignes et des colonnes, chaque pixel étant adapté pour générer un signal fonction d'un phénomène physique,
- un générateur de signaux, configuré pour générer deux signaux d'horloges déphasés l'un par rapport à l'autre,
- un dispositif d'adressage des lignes comprenant un registre à décalage, le registre à décalage comprenant une pluralité d'étages disposés en cascade, chaque étage étant apte à recevoir, en alternance d'un étage à l'autre, un signal d'horloge parmi les deux signaux d'horloges, et étant apte à délivrer un signal de sortie intermédiaire pouvant prendre un niveau haut et un niveau bas, permettant respectivement d'activer et de désactiver les pixels de la ligne,
caractérisé en ce que le générateur de signaux est également configuré pour générer un troisième signal d'horloge, le dispositif d'adressage comprenant également une pluralité de circuit d'isolation, chaque circuit d'isolation étant connecté entre chaque étage et la ligne correspondante de la matrice, et configuré pour recevoir le troisième signal d'horloge, le circuit d'isolation étant configuré pour délivrer un signal de sélection de la ligne correspondante de la matrice lorsque le signal de sortie intermédiaire et le troisième signal d'horloge sont au niveau haut.

Avantageusement, le circuit d'isolation comprend une borne d'entrée, apte à recevoir le signal de sortie intermédiaire, une borne de sortie, configuré pour délivrer le signal de sélection, un premier transistor dit d'isolation, dont la grille est connectée à la borne d'entrée par l'intermédiaire d'un transistor monté en diode, dont la source est connectée à la borne de sortie, et dont le drain est connecté pour recevoir le troisième signal d'horloge, et un condensateur d'élévation, disposé entre la grille et la source du premier transistor d'isolation.

Avantageusement, le circuit d'isolation comprend un deuxième transistor dit d'isolation, configuré pour isoler la borne de sortie vis à vis du condensateur d'élévation lorsqu'il est bloquant.

Avantageusement, le circuit d'isolation comprend un circuit d'abaissement d'impédance, connecté entre la grille du premier transistor d'isolation et la borne de sortie, et configuré pour maintenir le potentiel de la ligne au niveau bas lorsque signal de sélection est au niveau bas.

Avantageusement, le circuit d'abaissement d'impédance comprend :
- un premier transistor du circuit d'abaissement d'impédance, dont le drain est relié à la source du premier transistor d'isolation, dont la source est reliée à une source de tension correspondant au niveau bas, et dont la grille est reliée à la grille du premier transistor d'isolation,
- un deuxième transistor du circuit d'abaissement d'impédance, dont le drain et la grille sont reliés à la grille du premier transistor d'isolation, et dont la source est reliée à la source de tension correspondant au niveau bas, et
- un troisième transistor du circuit d'abaissement d'impédance, commandé par un premier signal de commande fourni par le générateur de signaux, et dont le drain est relié à la grille du premier transistor d'isolation.

Avantageusement, chaque étage comprend un premier transistor de réinitialisation, configuré pour désactiver simultanément les pixels de toutes les lignes, et dont la grille est commandée par une impulsion d'un signal de réinitialisation fourni par le générateur de signaux.

Avantageusement, chaque circuit d'isolation comprend un deuxième transistor de réinitialisation, configuré pour activer simultanément les pixels de toutes les lignes, et dont la grille est commandée par l'impulsion du signal de réinitialisation, et dont la source est apte à recevoir un deuxième signal de commande.

Les dessins annexés illustrent l'invention :
[Fig.1] La figure 1, déjà décrite, représente l'agencement en lignes et en colonnes de pixels, selon l'état de la technique.
[Fig.2] La figure 2, déjà décrite, représente le schéma électrique de deux étages d'un registre à décalage, selon l'état de la technique.
[Fig.3] La figure 3, représente le schéma électrique d'un étage et d'un circuit d'isolation selon l'invention.
[Fig.4] La figure 4 représente un diagramme des temps illustrant le fonctionnement du dispositif d'adressage de lignes selon l'invention.

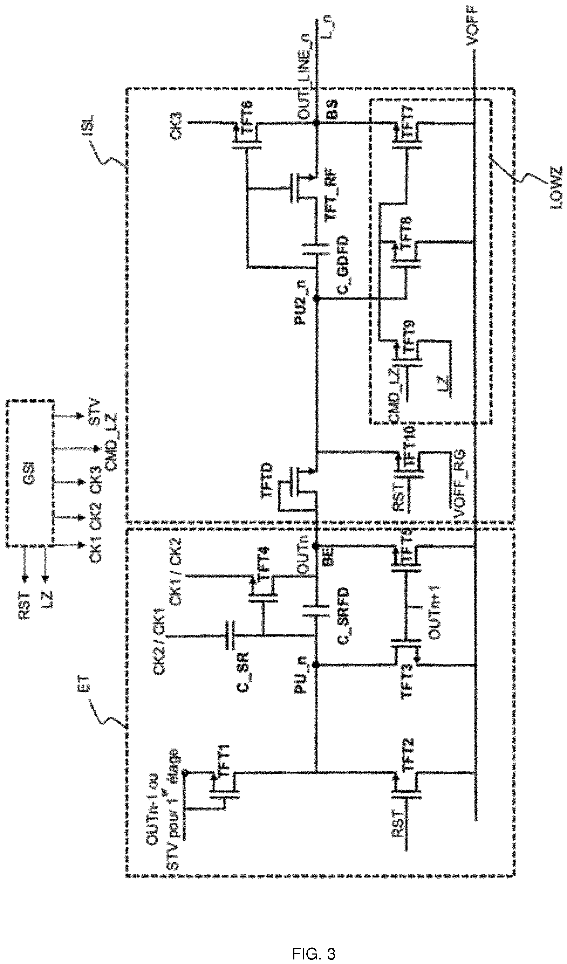

La figure 3 représente le schéma électrique d'un étage ET du dispositif d'adressage, tel que décrit précédemment. L'étage correspond à une ligne L_n, il peut s'agir indifféremment d'une ligne paire ou d'une ligne impaire. Le drain du transistor de sortie TFT4 reçoit un signal d'horloge ; par convention on définit que le transistor de sortie TFT4 d'une ligne impaire reçoit, au niveau de son drain, le premier signal d'horloge CK1, et que le transistor de sortie TFT4 d'une ligne paire reçoit, au niveau de son drain, le deuxième signal d'horloge CK2.

Un condensateur de compensation C_SR peut être disposé entre l'autre signal d'horloge (CK2 si le drain du transistor de sortie TFT4 reçoit CK1, et inversement) et la grille du transistor de sortie TFT4. Le condensateur de compensation C_SR a de préférence une valeur équivalente à celle de la capacité parasite située entre la grille et le drain du transistor de sortie TFT4. En variante, le condensateur de compensation C_SR peut être remplacé par un transistor. La taille du transistor remplaçant le condensateur de compensation C_SR est dans ce cas égale à la moitié de celle du transistor de sortie TFT4. Ainsi, la capacité totale est équivalente à la capacité entre la grille et le drain du transistor de sortie TFT4 (les TFT étant généralement parfaitement symétriques).

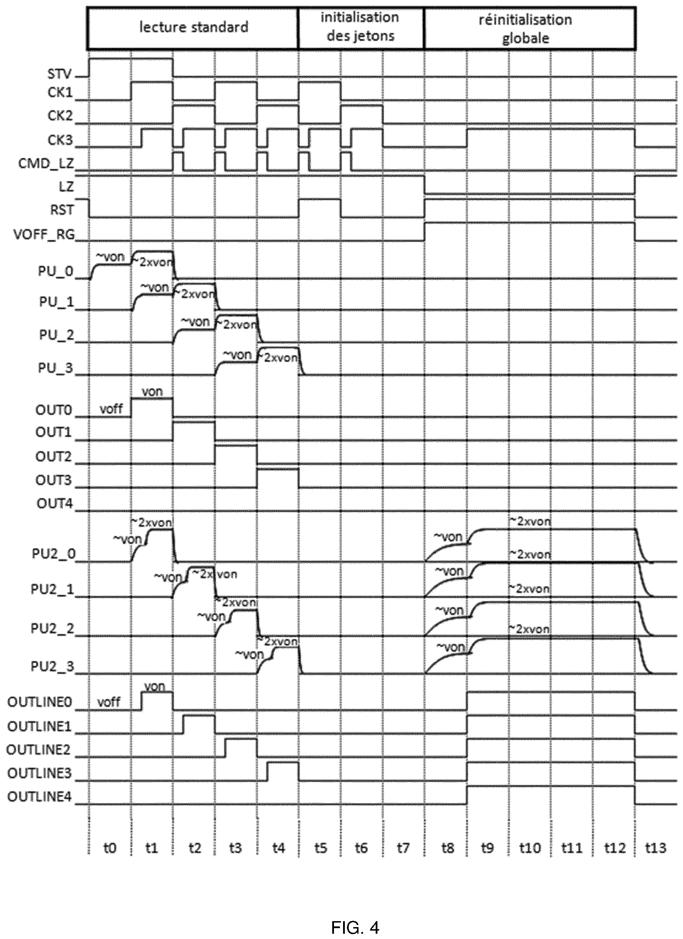

La figure 4 représente un diagramme des temps, illustrant notamment le fonctionnement des quatre premiers étages ET du dispositif d'adressage (sous la colonne « lecture standard »).

On définit PU_n comme étant un premier noeud interne de l'étage ET, connecté entre la source du premier transistor de commande TFT1 et la grille du transistor de sortie TFT4. Dans la figure 4, le signal PU_n correspond à la tension entre le premier noeud interne PU_n et la tension de référence Voff. On définit également une borne d'entrée BE, connecté entre la source du transistor de sortie TFT4 et le drain du transistor de décharge TFT5. La borne d'entrée BE est configurée pour recevoir un signal de sortie intermédiaire OUT_n. Le signal de sortie intermédiaire OUT_n peut prendre un niveau haut Von, qui correspond à une tension suffisante pour rendre passants les transistors des pixels de la ligne correspondante, ou un niveau bas, pour les rendre bloquants.

En référence à la figure 4, à l'instant t0, le premier transistor de commande de TFT1 de l'étage ET0 reçoit une impulsion d'entrée STV (tension Von), générée par un générateur de signaux GSI. Le premier transistor de commande de l'étage TFT1 est donc passant, et charge le condensateur d'élévation C_SRFD. Le potentiel du premier noeud interne PU_0 monte jusqu'à la tension Von, à laquelle il faut retrancher la tension de seuil (V_{TFT1}) du premier transistor de commande de l'étage TFT1.

A l'instant t1, le drain du transistor de sortie TFT4 reçoit un coup d'horloge du premier signal d'horloge CK1. Comme le premier noeud interne PU_0 a été chargé au niveau de tension de précharge Von-V_{TFT1}, le transistor de sortie TFT4 est passant. Le premier signal d'horloge CK1 est au niveau haut Von, la source du transistor de sortie TFT4 suit, entraînant la grille du transistor de sortie TFT4, qui est flottante, grâce au condensateur d'élévation C_SRFD. La tension du premier noeud interne PU_0 passe à 2xVon, le transistor de sortie TFT4 est alors largement passant, et le signal de sortie intermédiaire Out0 suit parfaitement le premier signal d'horloge Ck1, jusqu'à sa descente à l'instant t2. Le premier transistor de commande TFT1 de l'étage suivant reçoit, à l'instant t1, le signal de sortie intermédiaire Out0 de l'étage précédent.

Le dispositif d'adressage comprend également un circuit d'isolation ISL. Le circuit d'isolation ISL est connecté entre chaque étage ET et la ligne LI correspondante de la matrice. Le circuit d'isolation ISL reçoit le signal de sortie intermédiaire Outn, et un troisième signal d'horloge CK3. Le principe de l'invention consiste à appliquer le même signal d'horloge CK3 sur tous les circuits d'isolation ISL connectés aux lignes de la matrice. Le signal d'horloge CK3 est un signal périodique, dont le niveau haut se répète à chaque passage au niveau haut du premier signal d'horloge CK1 et du deuxième signal d'horloge CK2.

Le circuit d'isolation ISL est configuré pour fournir un signal de sélection OUT_LINE_n à la ligne L_n correspondante de la matrice. Le signal de sélection OUT_LINE_n peut passer d'un niveau haut (tension Von) permettant de sélectionner les pixels de la ligne, afin que les charges détectées soient lues, à un niveau bas (tension Voff). Le signal de sélection OUT_LINE_n est délivré par une borne de sortie BS, connectée à la ligne L_n.

Le circuit d'isolation ISL comprend un premier transistor d'isolation TFT6. Le drain du premier transistor d'isolation TFT6 reçoit le troisième signal d'horloge CK3. Le premier transistor d'isolation TFT6 permet ainsi de faire passer le jeton transmis par l'étage ET lorsque le troisième signal d'horloge CK3 est à Von. Un condensateur d'élévation C_GDFD, qui permet d'obtenir l'effet « bootstrap », est relié d'une part à la grille du premier transistor d'isolation TFT6, et d'autre part à la borne de sortie BS. Par ailleurs, un transistor monté en diode TFTD, dont la grille est reliée à la source, est disposé entre la borne d'entrée BE et la grille du premier transistor d'isolation TFT6. Le transistor monté en diode TFTD permet de ne faire passer que les tensions positives. On appelle deuxième noeud interne PU2_n le noeud situé entre le drain du transistor monté en diode TFTD et la grille du c.

Le fonctionnement du circuit d'isolation est décrit en lien avec la figure 4. A l'instant t1, le signal de sortie intermédiaire OUT_0 est à Von. Le transistor monté en diode TFTD est donc passant et charge le condensateur d'élévation C_GDFD tant que le troisième signal d'horloge CK3 est à Voff. Le potentiel du deuxième noeud interne PU2_0 monte jusqu'à la tension Von, à laquelle il faut retrancher la tension de seuil (V_{TFTD}) du transistor monté en diode TFTD. Le premier transistor d'isolation TFT6 est alors légèrement passant.

Lorsque le troisième signal d'horloge CK3 passe à Von, le chargement du deuxième noeud interne PU2_0 à la tension de précharge Von-V_{TFTD} rend passant le premier transistor d'isolation TFT6. La source du premier transistor d'isolation TFT6 suit, entraînant la grille du premier transistor d'isolation TFT6, qui est flottante, grâce au condensateur d'élévation C_GDFD. La tension du deuxième noeud interne PU2_0 passe à 2xVon, le premier transistor d'isolation TFT6 est alors largement passant, et le signal de sélection OUT_LINE_0 passe à Von.

De la même manière, par propagation du jeton dans les étages successifs du registre à décalage, à l'instant t2, le signal de sélection OUT_LINE_1 passe à Von, lorsque le troisième signal d'horloge CK3 est à Von.

Le rapport cyclique du troisième signal d'horloge CK3, à savoir le rapport, sur une période, entre la durée à Von et la durée à Voff, peut être déterminée de façon le temps au deuxième noeud interne PU2_n de monter à Von, et en mettant tout de même la durée à Von la plus longue possible, car c'est lorsque c'est lorsque le troisième signal d'horloge CK3 est à Von qu'est effectuée la lecture de la matrice. Le rapport cyclique peut donc être déterminé en fonction de la vitesse de commutation des TFT du dispositif d'adressage. Le rapport cyclique peut, par exemple, être déterminé par simulation, en fonction des valeurs des différents composants du dispositif d'adressage.

L'effet pair/impair, présent au niveau de la borne d'entrée BE, est fortement réduit au niveau de la borne de sortie BS, grâce au troisième signal d'horloge CK3 qui est commun à toutes les lignes de la matrice.

Selon un mode de réalisation particulièrement avantageux, un deuxième transistor d'isolation TFT_RF est disposé entre le condensateur d'élévation C_GDFD et la borne de sortie BS. La grille du deuxième transistor d'isolation TFT_RF est reliée à la grille du premier transistor d'isolation TFT6.

Le deuxième transistor d'isolation TFT_RF permet d'isoler le couplage parasite encore présent dans le condensateur d'élévation C_GDFD. Le deuxième transistor d'isolation TFT_RF et le premier transistor d'isolation TFT6 sont commandés par le même signal. Ainsi, le deuxième transistor d'isolation TFT_RF est passant lorsque le jeton se propage dans le circuit d'isolation ISL, et bloquant le reste du temps. Le deuxième transistor d'isolation TFT_RF isole le condensateur d'élévation C_GDFD, sauf lorsque la ligne doit être activée. Le deuxième transistor d'isolation TFT_RF comprend également une capacité parasite, mais sa valeur est nettement inférieure à celle du condensateur d'élévation C_GDFD.

Selon un autre mode de réalisation, le circuit d'isolation ISL comprend un circuit d'abaissement d'impédance LOWZ, connecté entre la grille du premier transistor d'isolation TFT6 et la borne de sortie BS. Le circuit d'abaissement d'impédance LOWZ permet de maintenir le potentiel de la ligne L_n à Voff lorsque signal de sélection OUT_LINE_n est à Voff. En maintenant le potentiel de la ligne à Voff, lorsque le jeton ne se propage pas dans l'étage, ce qu'il reste de couplage parasite est supprimé.

Le circuit d'abaissement d'impédance LOWZ permet également d'éviter les que les transistors des pixels ne soient polarisés en permanence, ce qui aurait pour conséquence d'accélérer leur vieillissement. Il permet également d'éviter l'apparition de jetons parasites, provoqués par une dérive des transistors.

Le circuit d'abaissement d'impédance LOWZ comprend un premier transistor du circuit d'abaissement d'impédance TFT7, dont le drain est relié à la source du premier transistor d'isolation TFT6, dont la source est reliée à la tension Voff, et dont la grille est reliée à la grille du premier transistor d'isolation TFT6. Il comprend également un deuxième transistor du circuit d'abaissement d'impédance TFT8, dont le drain et la grille sont reliés à la grille du premier transistor d'isolation TFT6, et dont la source est reliée à la tension Voff. Il comprend enfin un troisième transistor du circuit d'abaissement d'impédance TFT9, commandé par un premier signal de commande CMD_LZ fourni par le générateur de signaux GSI, et dont le drain est relié à la grille du premier transistor d'isolation TFT6.

Lorsque le deuxième noeud interne PU2_n passe à Von, qui correspond à l'arrivée d'un jeton en provenance de l'étage ET, le deuxième transistor du circuit d'abaissement d'impédance TFT8 devient passant, et laisse ainsi passer Voff. Le premier transistor du circuit d'abaissement d'impédance TFT7 devient donc non passant, donc il n'impose plus Voff au niveau de la borne de sortie BS, donc le jeton peut passer, la ligne peut être adressée.

En l'absence de jeton arrivant de l'étage ET, le deuxième noeud interne PU2_n reste à l'état Voff, le deuxième transistor du circuit d'abaissement d'impédance TFT8 reste non passant et la grille du premier transistor du circuit d'abaissement d'impédance TFT7 reste à Von ; celui-ci reste passant et impose Voff sur la ligne.

Le premier signal de commande CMD_LZ permet au troisième transistor du circuit d'abaissement d'impédance TFT9 de ne pas être en permanence à Von. Le signal de commande LZ, qui arrive à la source du troisième transistor du circuit d'abaissement d'impédance TFT9, est en effet en permanence à Von. Le premier signal de commande CMD_LZ peut donc avoir un rapport cyclique, de préférence inversé par rapport à celui du troisième signal d'horloge CK3 : il est principalement à Voff, sauf pendant un court instant, durant lequel il passe à Von, ainsi qu'illustré dans le chronogramme en figure 4.

Le potentiel de grille du premier transistor du circuit d'abaissement d'impédance TFT7 est donc remis régulièrement (à chaque fois qu'une ligne est adressée) à Von et assure que le premier transistor du circuit d'abaissement d'impédance TFT7 soit passant tant que le deuxième noeud interne PU2_n ne passe pas à Von. La grille du premier transistor du circuit d'abaissement d'impédance TFT7 n'est pas maintenue en permanence à Von grâce au premier signal de commande CMD_LZ ; ceci permet que le deuxième transistor du circuit d'abaissement d'impédance TFT8 fasse passer facilement la grille du premier transistor du circuit d'abaissement d'impédance TFT7 à Voff lorsque le deuxième noeud interne PU2_n est à Von. Cela permet également d'éviter des éventuels court-circuits provoqués par un état passant à la fois du deuxième transistor du circuit d'abaissement d'impédance TFT8 et du troisième transistor du circuit d'abaissement d'impédance TFT9.

Le détecteur matriciel permet ainsi d'obtenir un seul et même effet parasite pour toutes les lignes de la matrice, qui peut être corrigé par des techniques connues, par exemple en effectuant, avant l'étape de détection, une prise d'image de blanc.

Avantageusement, chaque étage ET peut également comprendre un transistor de réinitialisation de l'étage TFT2 dont la grille est commandée par une impulsion d'un signal de réinitialisation RST. La source du transistor de réinitialisation TFT2 est connectée à la source du deuxième transistor de commande TFT3 et à la source du transistor de décharge TFT5. Le drain du transistor de réinitialisation TFT2 peut être connecté au drain du deuxième transistor de commande de l'étage d'entrée TFT3.

En référence à la figure 4 (sous la colonne « réinitialisation des jetons »), lorsqu'une impulsion du signal de réinitialisation RST est reçue au niveau de la grille du transistor de réinitialisation de l'étage TFT2. Ainsi, une impulsion de réinitialisation permet de rendre bloquant immédiatement les différents transistors compris dans l'étage ET.

Selon un mode de réalisation préférentiel, chaque circuit d'isolation ISL comprend un deuxième transistor de réinitialisation TFT10, configuré pour activer simultanément les pixels de toutes les lignes. La grille du deuxième transistor de réinitialisation TFT10 est commandée par l'impulsion du signal de réinitialisation RST, et la source est apte à recevoir un deuxième signal de commande Voff_RG.

La figure 4 (sous la colonne « réinitialisation globale ») permet de comprendre l'utilité du deuxième transistor de réinitialisation TFT10, commandé par un signal de commande.

En fonctionnement standard, Voff_RG = Voff ce qui permet d'avoir un schéma équivalent au précédent avec la fonction de reset inchangée. Ainsi, tous les transistors du circuit d'isolation ISL deviennent bloquants.

Lorsqu'une réinitialisation globale doit être effectuée, on applique les commandes suivantes : Voff_RG=Von, RST = Von et LZ=Voff.

L'étage ET est alors réinitialisé par la commande RST, comme indiqué précédemment. A t8, le deuxième noeud interne PU2_n monte à Von sur toutes les lignes en même temps (la commande LZ est désactivée, LZ = 0). Puis, à t9,le troisième signal d'horloge CK3 est mis à Von, pour monter tous les signaux de sélection à Von.

Ensuite, en imposant Voff_RG = Voff et LZ = Von, à t13, tous les étages du GOA vont se remettre à Voff et l'électronique peut être éteinte.

Cette fonction de réinitialisation globale est particulièrement avantageuse en termes de consommation de puissance. Lors de l'utilisation d'un capteur de manière non constante, par exemple pour de la reconnaissance d'empreinte digitale sur un appareil électronique, à l'aide du détecteur matriciel, il est nécessaire de contrôler la puissance consommée. Par exemple, la fonction de reconnaissance est utilisée environ 0.1% du temps au maximum. Il est donc nécessaire d'éteindre l'électronique de lecture pendant les temps morts.

Une électronique de lecture peut consommer environ 500 mW lors de la prise d'image soit 135 mA sous les 3.7 V d'une batterie de téléphone (de type « Smartphone ») soit environ une consommation de 10% de la batterie si elle n'est pas éteinte.

Or éteindre les alimentations d'une matrice de photodiode pendant un temps très long implique que le temps de réveil sera très long (quelques secondes) lié au fait que les photodiodes non polarisées se mettent dans un état très différent d'une photodiode polarisée et plusieurs dizaines images sont nécessaires pour stabiliser la matrice.

La fonction de réinitialisation globale, rendue possible par l'existence d'un troisième signal d'horloge CK3, permet de conserver la tension de polarisation positive pour polariser les photodiodes, et de faire un une réinitialisation régulière des photodiodes afin de conserver en permanence un état stable.

## Revendications

1. Détecteur matriciel comprenant :
- un ensemble de pixels organisés en matrice selon des lignes (L) et des colonnes, chaque pixel (P) étant adapté pour générer un signal fonction d'un phénomène physique,
- un générateur de signaux (GSI), configuré pour générer deux signaux d'horloges (CK1, CK2) déphasés l'un par rapport à l'autre,
- un dispositif d'adressage des lignes comprenant un registre à décalage (SR), le registre à décalage (SR) comprenant une pluralité d'étages (ET) disposés en cascade, chaque étage (ET) étant apte à recevoir, en alternance d'un étage à l'autre, un signal d'horloge parmi les deux signaux d'horloges (CK1, CK2), et étant apte à délivrer un signal de sortie intermédiaire (OUTn) pouvant prendre un niveau haut (Von) et un niveau bas (Voff), permettant respectivement d'activer et de désactiver les pixels de la ligne,
le générateur de signaux (GSI) étant également configuré pour générer un troisième signal d'horloge (CK3), le dispositif d'adressage comprenant également une pluralité de circuit d'isolation (ISL), chaque circuit d'isolation (ISL) étant connecté entre chaque étage (ET) et la ligne (LI) correspondante de la matrice, et configuré pour recevoir le troisième signal d'horloge (CK3), le circuit d'isolation (ISL) étant configuré pour délivrer un signal de sélection (OUT_LINE n) de la ligne correspondante de la matrice lorsque le signal de sortie intermédiaire (OUTn) et le troisième signal d'horloge (CK3) sont au niveau haut (Von).
dans lequel le circuit d'isolation (ISL) comprend une borne d'entrée (BE), apte à recevoir le signal de sortie intermédiaire (OUTn), une borne de sortie (BS), configuré pour délivrer le signal de sélection (OUT_LINE n), un premier transistor dit d'isolation (TFT6), dont la grille est connectée à la borne d'entrée (BE) par l'intermédiaire d'un transistor monté en diode (TFTD), dont la source est connectée à la borne de sortie (BS), et dont le drain est connecté pour recevoir le troisième signal d'horloge (CK3), et un condensateur d'élévation (C_GDFD), disposé entre la grille et la source du premier transistor d'isolation (TFT6),
**caractérisé en ce que** le circuit d'isolation (ISL) comprend un deuxième transistor dit d'isolation (TFT_RF), configuré pour isoler la borne de sortie (BS) vis à vis du condensateur d'élévation (C_GDFD) lorsqu'il est bloquant.

2. Détecteur matriciel selon la revendication 1, dans lequel le circuit d'isolation (ISL) comprend un circuit d'abaissement d'impédance (LOWZ), connecté entre la grille du premier transistor d'isolation (TFT6) et la borne de sortie (BS), et configuré pour maintenir le potentiel de la ligne (L) au niveau bas (Voff) lorsque signal de sélection (OUT_LINE_n) est au niveau bas (Voff).

3. Détecteur matriciel selon la revendication 2, dans lequel le circuit d'abaissement d'impédance (LOWZ) comprend :
- un premier transistor du circuit d'abaissement d'impédance (TFT7), dont le drain est relié à la source du premier transistor d'isolation (TFT6), dont la source est reliée à une source de tension (Voff) correspondant au niveau bas, et dont la grille est reliée à la grille du premier transistor d'isolation (TFT6),
- un deuxième transistor du circuit d'abaissement d'impédance (TFT8), dont le drain et la grille sont reliés à la grille du premier transistor d'isolation (TFT6), et dont la source est reliée à la source de tension (Voff) correspondant au niveau bas, et
- un troisième transistor du circuit d'abaissement d'impédance (TFT9), commandé par un premier signal de commande (CMD_LZ) fourni par le générateur de signaux (GSI), et dont le drain est relié à la grille du premier transistor d'isolation (TFT6).

4. Détecteur matriciel selon la revendication 3, dans lequel chaque étage (ET) comprend un premier transistor de réinitialisation (TFT2), configuré pour désactiver simultanément les pixels de toutes les lignes, et dont la grille est commandée par une impulsion d'un signal de réinitialisation (RST) fourni par le générateur de signaux (GSI).

5. Détecteur matriciel selon la revendication 4, dans lequel chaque circuit d'isolation (ISL) comprend un deuxième transistor de réinitialisation (TFT10), configuré pour activer simultanément les pixels de toutes les lignes, et dont la grille est commandée par l'impulsion du signal de réinitialisation (RST), et dont la source est apte à recevoir un deuxième signal de commande (VOFF_RG).

## Patentansprüche

1. Ein Matrix-Array Detektor, des Folgendes aufweist:
- ein Array von Pixeln, die in einer Matrix entlang Zeilen (L) und Spalten angeordnet sind, wobei jeder Pixel (P) in der Lage ist ein Signal gemäß eines physikalischen Effekts zu generieren;
- ein Signal-Generator (GSI), der konfiguriert ist zum Generieren von zwei Taktsignalen (CK1, CK2), die relativ zueinander phasenverschoben sind;
- ein Zeilen-Adressierung-Gerät, das ein Schieberegister (SR) aufweist, wobei das Schieberegister (SR) eine Vielzahl von Stufen (ET) aufweist, die in einer Kaskade angeordnet sind, wobei jede Stufe (ET) in der Lage ist, in Wechselfolge von einer Stufe zur nächsten, ein Taktsignal der zwei Taktsignale (CK1, CK2) zu empfangen, und in der Lage ist ein zwischenliegendes Ausgangssignal (OUTn) zu liefern, das in der Lage ist eine hohen Wert (Von) und einen niedrigen Wert (Voff) anzunehmen, um es den Pixeln der Zeile jeweils zu ermöglichen aktiviert oder deaktiviert zu werden,
wobei der Signal-Generator (GSI) ferner konfiguriert ist zum Generieren eines dritten Taktsignals (CK3), das Adressierung-Gerät ferner eine Vielzahl von Isolationsschaltungen (ISL) aufweist, jede Isolationsschaltung (ISL) zwischen jeder Stufe (EP) und der entsprechenden Zeile (LI) der Matrix verbunden ist und konfiguriert ist das dritte Taktsignal (CK3) zu empfangen, die Isolationsschaltung (ISL) ferner konfiguriert ist ein Auswahlsignal (OUT_LINE_n) zu liefern zum Auswählen der entsprechenden Zeile der Matrix, wenn das zwischenliegende Ausgangssignal (OUTn) und das dritte Taktsignal (CK3) auf dem hohen Niveau (Von) sind,
wobei die Isolationsschaltung (ISL) eine Eingangsschnittstelle (BE) aufweist, die in der Lage ist das zwischenliegende Ausgangssignal (OUTn) zum empfangen, eine Ausgangsschnittstelle (BS), die konfiguriert ist um das Auswahlsignal (OUT_LINE_n) zu liefern, ein erster Transistor, der als ein Isolationstransistor (TFT6) bezeichnet wird, dessen Gate mit der Eingangsschnittstelle (BE) über einen Dioden-verbundenen Transistor (TFTD) verbunden ist, dessen Source mit der Ausgangsschnittstelle (BS) verbunden ist und dessen Drain verbunden ist um das dritte Taktsignal (CK3) zu empfangen, und ein Boost-Kondensator (C-GDFD) der zwischen dem Gate und der Source des ersten Isolationstransistors (TFT6) angeordnet ist,
**gekennzeichnet dadurch, dass** die Isolationsschaltung (ISL) einen zweiten Transistor aufweist, der als ein Isolationstransistor (TFT_RF) bezeichnet wird, der konfiguriert ist, die Ausgangsschnittstelle (BS) von dem Boost-Kondensator (C-GDFD) zu isolieren, wenn er ausgeschaltet ist.

2. Der Matrix-Array Detektor nach Anspruch 1, wobei die Isolationsschaltung (ISL) eine Impedanz-verringernde Schaltung (LOWZ) aufweist, die zwischen dem Gate des ersten Isolationstransistors (TFT6) und der Ausgangsschnittstelle (BS) verbunden ist, und konfiguriert ist, das Potential der Zeile (L) auf dem niedrigen Niveau (Voff) zu halten, wenn das Auswahlsignal (OUT_LINE_n) auf dem niedrigen Niveau (Voff) ist.

3. Der Matrix-Array Detektor nach Anspruch 2, wobei die Impedanz-verringernde Schaltung (LOWZ) Folgendes aufweist:
- einen ersten Transistor der Impedanz-verringernden Schaltung (TFT7), dessen Drain mit der Source des ersten Isolationstransistors (TFT6) verbunden ist, dessen Source mit einer Spannungsquelle (Voff) verbunden ist, die dem niedrigen Niveau entspricht, und dessen Gate mit dem Gate des ersten Isolationstransistors (TFT6) verbunden ist;
- ein zweiter Transistor der Impedanz-verringernden Schaltung (TFT8), dessen Drain und Gate mit dem Gate des ersten Isolationstransistors (TFT6) verbunden ist und dessen Source mit der Spannungsquelle (Voff) verbunden ist, die dem niedrigen Niveau entspricht; und
- ein dritter Transistor der Impedanz-verringernden Schaltung (TFT9), der durch ein erstes Steuersignal (CMD_LZ) gesteuert wird, das von dem Signal-Generator (GSI) geliefert wird und dessen Drain mit dem Gate des ersten Isolationstransistors (TFT6) verbunden ist.

4. Der Matrix-Array Detektor nach Anspruch 3, wobei jede Stufe (ET) einen ersten Reset-Transistor (TFT2) aufweist, der konfiguriert ist, die Pixel aus allen Zeilen gleichzeitig auszuschalten, dessen Gate durch einen Puls eines Reset-Signals (RST) gesteuert wird, das von dem Signal-Generator (GSI) geliefert wird.

5. Der Matrix-Array Detektor nach Anspruch 4, wobei jede Isolationsschaltung (ISL) einen zweiten Reset-Transistor (TFT10) aufweist, der konfiguriert ist, die Pixel aus allen Zeilen gleichzeitig einzuschalten, dessen Gate durch einen Puls des Reset-Signals (RST) gesteuert wird und dessen Source in der Lage ist ein zweites Steuersignal (VOFF_RG) zu empfangen.

## Claims

1. Matrix-array detector comprising:
- an array of pixels arranged in a matrix along rows (L) and down columns, each pixel (P) being capable of generating a signal according to a physical effect;
- a signal generator (GSI) configured to generate two clock signals (CK1, CK2) that are phase-shifted relative to one another;
- a row-addressing device comprising a shift register (SR), the shift register (SR) comprising a plurality of stages (ET) arranged in a cascade, each stage (ET) being capable of receiving, in alternation from one stage to another, one clock signal from the two clock signals (CK1, CK2), and being capable of delivering an intermediate output signal (OUTn) that is able to take a high value (Von) and a low value (Voff) allowing the pixels of the row to be activated and to be deactivated, respectively,
the signal generator (GSI) also being configured to generate a third clock signal (CK3), the addressing device also comprising a plurality of isolation circuits (ISL), each isolation circuit (ISL) being connected between each stage (EP) and the corresponding row (LI) of the matrix, and configured to receive the third clock signal (CK3), the isolation circuit (ISL) being configured to deliver a selection signal (OUT_LINE_n) for selecting the corresponding row of the matrix when the intermediate output signal (OUTn) and the third clock signal (CK3) are at the high level (Von),
wherein the isolation circuit (ISL) comprises an input terminal (BE) capable of receiving the intermediate output signal (OUTn), an output terminal (BS) configured to deliver the selection signal (OUT_LINE_n), a first transistor referred to as an isolation transistor (TFT6), the gate of which is connected to the input terminal (BE) via a diode-connected transistor (TFTD), the source of which is connected to the output terminal (BS) and the drain of which is connected to receive the third clock signal (CK3), and a boost capacitor (C_GDFD) that is arranged between the gate and the source of the first isolation transistor (TFT6),
**characterized in that** the isolation circuit (ISL) comprises a second transistor referred to as an isolation transistor (TFT_RF) configured to isolate the output terminal (BS) from the boost capacitor (C_GDFD) when it is off.

2. Matrix-array detector according to Claim 1, wherein the isolation circuit (ISL) comprises an impedance-lowering circuit (LOWZ) connected between the gate of the first isolation transistor (TFT6) and the output terminal (BS), and configured to maintain the potential of the row (L) at the low level (Voff) when the selection signal (OUT_LINE_n) is at the low level (Voff).

3. Matrix-array detector according to Claim 2, wherein the impedance-lowering circuit (LOWZ) comprises:
- a first transistor of the impedance-lowering circuit (TFT7), the drain of which is connected to the source of the first isolation transistor (TFT6), the source of which is connected to a voltage source (Voff) corresponding to the low level and the gate of which is connected to the gate of the first isolation transistor (TFT6);
- a second transistor of the impedance-lowering circuit (TFT8), the drain and the gate of which are connected to the gate of the first isolation transistor (TFT6) and the source of which is connected to the voltage source (Voff) corresponding to the low level; and
- a third transistor of the impedance-lowering circuit (TFT9), controlled by a first control signal (CMD_LZ) delivered by the signal generator (GSI) and the drain of which is connected to the gate of the first isolation transistor (TFT6).

4. Matrix-array detector according to Claim 3, wherein each stage (ET) comprises a first reset transistor (TFT2) configured to deactivate the pixels of all of the rows simultaneously, the gate of which is controlled by a pulse of a reset signal (RST) delivered by the signal generator (GSI) .

5. Matrix-array detector according to Claim 4, wherein each isolation circuit (ISL) comprises a second reset transistor (TFT10) configured to activate the pixels of all of the rows simultaneously, the gate of which is controlled by the pulse of the reset signal (RST) and the source of which is capable of receiving a second control signal (VOFF_RG).
